**Europäisches Patentamt**

**European Patent Office**

**Office européen des brevets**

(19)

(11)     **EP 0 995 265 B1**

(12)     **EUROPÄISCHE PATENTSCHRIFT**

(45) Veröffentlichungstag und Bekanntmachung des Hinweises auf die Patenterteilung:
   **02.05.2003   Patentblatt 2003/18**

(51) Int Cl.$^7$: **H03H 9/64**

(21) Anmeldenummer: **98943697.7**

(22) Anmeldetag: **14.07.1998**

(86) Internationale Anmeldenummer:
   **PCT/DE98/01972**

(87) Internationale Veröffentlichungsnummer:
   **WO 99/004490 (28.01.1999 Gazette 1999/04)**

(54) **OBERFLÄCHENWELLENAKUSTIKFILTER MIT VERBESSERTER FLANKENSTEILHEIT**

SURFACE ACOUSTIC WAVE FILTER WITH ENHANCED EDGE STEEPNESS

FILTRE A ONDES ACOUSTIQUES DE SURFACE A PENTE DU SIGNAL AMELIOREE

(84) Benannte Vertragsstaaten:
   **DE FR GB**

(30) Priorität: **17.07.1997   DE 19730710**

(43) Veröffentlichungstag der Anmeldung:
   **26.04.2000   Patentblatt 2000/17**

(73) Patentinhaber: **EPCOS AG**
   **81541 München (DE)**

(72) Erfinder:
   • **SELMEIER, Peter**
    **D-83558 Maitenbeth (DE)**
   • **PITSCHI, Maximilian**
    **D-83700 Rottach-Egern (DE)**

(74) Vertreter: **Epping, Wilhelm, Dipl.-Ing. et al**
   **Epping Hermann & Fischer**
   **Postfach 12 10 26**
   **80034 München (DE)**

(56) Entgegenhaltungen:
   **EP-A- 0 541 284         EP-A- 0 614 272**
   **DE-A- 4 115 080        DE-A- 4 408 989**
   **DE-A- 19 638 627**

**Beschreibung**

Die Erfindung betrifft einen Oberflächenwellenakustikfilter (SAW-Filter) vom Resonatortyp, welches als Bandpaßfilter mit niedrigem Verlust und großen Sperrbereichsabschwächungsverhältnis insbesondere als Ein- oder Ausgangsfilter für Schnurlose oder Mobiltelefone geeignet ist.

Ein SAW-Filter des genannten Typs ist beispielsweise aus DE 44 08 989 C bekannt. Dieses weist eine Vielzahl von Oberflächenakustikwellenresonatoren auf, die seriell und parallel miteinander verbunden sind. Jeder der Resonatoren umfaßt einen Interdigitalwandler, der zwischen zwei Reflektoren angeordnet ist. Sowohl die Elektrodenfinger des Interdigitalwandlers als auch die z. B. gitterartig angeordneten Reflektoren weisen eine Fingerperiodizität auf, die im wesentlichen der halben Wellenlänge der Resonanzfrequenz entspricht. Dadurch können sich sowohl die an den einzelnen Elektrodenfingern beziehungsweise Reflektoren erzeugten bzw. reflektierten akustischen Oberflächenwellen durch konstruktive Interferenz optimal verstärken. Ein HF-Signal kann so nahezu verlustfrei von einem Anschluß des Oberflächenwellenresonators zum anderen übertragen werden. Durch die serielle und parallele Verschaltung mehrerer Resonatoren wird außerdem bewirkt, daß außerhalb des Durchlaßbereichs liegende Frequenzen weiter abgeschwächt werden und so die Sperrbereichsunterdrückung vergrößert wird. Außerhalb des Durchlaßbereichs wird bei SAW-Filtern vom Resonatortyp eine optimale Sperrbereichsunterdrückung erhalten, wenn die Fingerperiodizität der Reflektoren und der Interdigitalwandler jeweils für sämtliche miteinander verschalteten serielllen beziehungsweise für jeweils alle miteinander verschalteten parallelen Resonatoren gleich ist. In der genannten deutschen Patentschrift wird zusätzlich vorgeschlagen, die Fingerperiodizität bzw. den Zwischenelektrodenabstand in den Reflektoren von dem Zwischenelektrodenabstand in den Interdigitalwandlern unterschiedlich einzustellen. Insbesondere wird dies für den Zwischenelektrodenabstand in den Reflektoren der seriell miteinander verbundenen Resonatoren vorgeschlagen. Damit wird bewirkt, daß eine bei bekannten Filtern außerhalb des Durchlaßbereichs auftretende Störspitze eliminiert wird.

Bei diesen und anderen bekannten SAW-Filtern vom Resonatortyp wird jedoch als nachteilig erachtet, daß bei der Durchlaßkurve die Flanken des Durchlaßbereichs nicht steil genug abfallen, bzw. daß der Übergang zwischen Durchlaßbereich und Sperrbereich nicht scharf genug erfolgt, so daß die Durchlaßkurve in diesen Bereich zu langsam abfällt bzw. zu abgerundete Kanten aufweist.

Aus der EP 0 614 272 A1 ist ein Oberflächenwellenfilter bekannt, bei dem in mehreren Spuren angeordnete Zweitor-Resonatoren parallel verschaltet sind. Die Resonatoren sind in Ihrer Resonanzfrequenz gegeneinander verstimmt und unterscheiden sich in der Fingerperiodizität der Wandler und der Reflektoren oder in der Länge des Resonanzraums.

Aus der EP-A-0 541 284 sind aus SAW Eintorresonatoren aufgebaute Filter mit Ladder type Verschaltung bekannt. In dieser Abzweigschaltung sind eine Reihe seriell verschalteter Resonatoren vorgesehen, die den Durchlaßbereich des Filters definieren. Vom seriellen Arm zweigen Parallelarme gegen Masse ab, in denen ebenfalls Eintorresonatoren angeordnet sind. Diese weisen eine niedrigere Resonanzfrequenz als die seriellen Resonatoren auf und bilden so die linke Flanke des Paßbandes.

Aufgabe der vorliegenden Erfindung ist es daher ein SAW-Filter vom Resonatortyp anzugeben, das bei guter Sperrbereichsunterdrückung dennoch einen ausreichend breiten Durchlaßbereich mit steil abfallenden Flanken aufweist.

Diese Aufgabe wird erfindungsgemäß durch ein SAW-Filter mit den Merkmalen von Anspruch 1 gelöst. Vorteilhafte Ausgestaltungen der Erfindung ergeben sich aus den Unteransprüchen.

Das erfindungsgemäße SAW-Filter weist zumindest zwei Resonatoren auf, die parallel und/oder in Serie miteinander verschaltet sind, bei dem entweder die seriell verschalteten und/oder die parallel verschalteten Resonatoren zumindest zwei unterschiedliche Fingerperiodizitäten der Interdigitalwandler aufweisen. Durch das Ausmaß dieser Abweichung der Fingerperiodizitäten läßt sich gezielt eine höhere Flankensteilheit des Durchlaßbereichs und insbesondere ein schärferer Übergang vom Durchlaßbereich in den Sperrbereich einstellen. Außerdem wird ein flacherer Durchlaßbereich mit gleichbleibend niedriger Durchlaßdämpfung erhalten. Dieses.Ergebnis ist überraschend und steht im Widerspruch zu den Werten, die man für eine derartige Anordnung erwarten konnte. Für Resonatoren mit unterschiedlicher Fingerperiodizität wird eigentlich eine geringere Flankensteilheit erwartet als für Filter mit parallel beziehungsweise seriell verschalteten Resonatoren, die eine gleiche Fingerperiodizität aufweisen. Mit der Erfindung wird jedoch ein SAW-Filter mit zumindest gleichbleibender Flankensteilheit erhalten.

Bei einem erfindungsgemäßen SAW-Filter ist es außerdem möglich, gezielt eine der beiden Flanken des Durchlaßbereichs steiler zu gestalten. Dies kann die Flanke sein, die den Durchlaßbereich hin zu höheren Frequenzen begrenzt, aber auch die Flanke, die den Durchlaßbereich zu niedrigeren Frequenzen hin begrenzt. Dies wird erreicht, wenn nur für serienverschaltete Resonatoren unterschiedliche Fingerperiodizitäten eingestellt werden, wobei die linke, zu niedrigeren Frequenzen hinweisende Flanke steiler eingestellt wird. Andererseits kann durch unterschiedliche Einstellung der Fingerperiodizität in den parallel verschalteten Resonatoren die rechte, zu höheren Frequenzen hinweisende Flanke des Durchlaßbereichs steiler gestaltet werden. Außerdem wird der Übergang vom Durchlaßbereich zur Flanke hin (z.B. im Bereich von 0 bis 3 dB relativer Dämpfung) abrupter gestaltet.

In einer vorteilhaften Ausgestaltung der Erfindung werden bei seriell verschalteten Resonatoren $R_{S1}$ bis $R_{Sn}$ (mit $n \geq 3$) zumindest drei unterschiedliche Fingerperiodizitäten gewählt, wobei der Resonator mit der größten Fingerperiodizität in der seriellen Verschaltung außen angeordnet wird, während der Resonator mit der geringsten Fingerperiodizität in der Mitte angeordnet wird. Bei mehr als drei seriell angeordneten Resonatoren ist der Resonator mit der geringsten Fingerperiodizität vorzugsweise nicht dem Resonator mit der größten Fingerperiodizität benachbart.

In einer weiteren vorteilhaften Ausgestaltung der Erfindung sind vier seriell verschaltete Resonatoren vorgesehen, wobei je ein serieller Resonator mit einem parallel dazu geschalteten Resonator ein Grundglied bildet, bei dem die parallel verschalteten Resonatoren entweder nur einem oder auch zwei benachbarten Grundgliedern zugerechnet werden können, bei dem für die Fingerperiodizität der Elektrodenfinger der seriellen Resonatoren drei unterschiedliche Werte eingestellt werden, wobei ein äußerer Resonator die höchste Fingerperiode aufweist, bei dem der Resonator mit der niedrigsten Fingerperiode innen liegt und bei dem der andere äußere und ein innerer Resonator die gleiche Fingerperiode aufweisen. Für vier seriell angeordnete Resonatoren $R_{S1}$ bis $R_{S4}$ gilt daher für deren Fingerperioden $P_S1$ bis $P_s4$: $P_{S2} < P_{S1} = P_{S3} < P_{S4}$ oder $P_{S3} < P_{S1} = P_{S2} < P_{S4}$ oder jeweils mit umgekehrter Reihung.

Allgemein gilt, daß mit höherer Anzahl seriell verschalteter Resonatoren eine bessere Sperrbereichsunterdrückung erreicht wird. Für erfindungsgemäße SAW-Filter wird bei gegebener Anzahl parallel verschalteter Resonatoren die maximale Anzahl seriell verschalteter Resonatoren gewählt, um bei minimaler Gesamtresonatorenanzahl eine maximale Variationsmöglichkeit für die Anordnung der Fingerperiodizitäten zu erhalten. So kann mit zwei parallelen Resonatoren und drei seriellen Resonatoren ein erfindungsgemäßes SAW-Filter mit drei Grundgliedern aufgebaut werden und mit vier seriellen und zwei parallelen Resonatoren ein erfindungsgemäßes SAW-Filter mit vier Grundgliedern aufgebaut werden.

Analog kann ein erfindungsgemäßes Filter drei Grundglieder mit einer maximalen Anzahl von parallelen Resonatoren und einer minimalen Anzahl serieller Resonatoren umfassen, wobei die Fingerperioden der Interdigitalwandler in den parallelen Resonatoren zumindest zwei, bei drei und mehr Grundgliedern aber drei verschiedene Werte aufweisen.

Desweiteren können zusätzliche in Serie geschaltete Resonatoren vorgesehen sein, die keinen benachbarten parallel geschalteten Resonator aufweisen, beziehungsweise die mit keinem parallel dazu geschalteten Resonator ein Grundglied bilden können.

In einer weiteren Ausgestaltung der Erfindung ist zumindest ein serieller Resonator durch zwei parallel geschaltete Resonatoren ersetzt, die mit ihren jeweiligen Ein- beziehungsweise Ausgängen miteinander verbunden sind.

Bezüglich der einzustellenden Unterschiede in den Fingerperiodizitäten haben sich Abweichungen von 0,1 bis 3 Prozent als geeignet und von 0,5 bis 1 Prozent als besonders vorteilhaft herausgestellt. Während sich bei größer werdenden Abweichungen der Fingerperiodizität die Eigenschaften und insbesondere der Durchlaßbereich des Filters wieder verschlechtert, ist mit geringer werdenden Abweichungen der Fingerperiodizität der erfindungsgemäße Effekt, nämlich die steilere Einstellung der Flanke des Durchlaßbereichs reduziert.

Die spezifische Einstellung einer höheren Flankensteilheit bei nur einer Flanke ist dann von Vorteil, wenn zwei benachbarte Frequenzbereiche gegeneinander abzutrennen sind. So weist beispielsweise das Mobilfunknetz nach dem GSM-Standard unterschiedliche Frequenzbereiche für Sender und Empfänger auf. Die sind beispielsweise um 20 MHz voneinander getrennt. Werden nun für Ein- bzw. Ausgangsfilter erfindungsgemäße SAW-Filter verwendet, so ist es möglich, spezifisch die Flanken der Durchlaßbereiche steiler zu gestalten, die den Durchlaßbereich zum benachbarten Durchlaßbereich des Sender- bzw. Empfängerbandes abgrenzen. Da das Senderband beim GSM-Standard unterhalb des Empfängerbandes liegt, werden vorteilhafterweise für das Sendeband Filter mit einer steilen rechten Flanke (hin zu höheren Frequenzen) beziehungsweise für das Empfängerband Filter mit einer steilen linken Flanke (hin zu niedrigeren Frequenzen) des Durchlaßbereichs verwendet.

Im folgenden wird die Erfindung anhand von Ausführungsbeispielen und der dazugehörigen sieben Figuren näher erläutert.

Figur 1     zeigt anhand schematischer Schaltbilder, wie Resonatoren miteinander verschaltet sein können.

Figur 2     zeigt schematisch den Aufbau eines Filters mit auf einem Substrat angeordneten Interdigitalwandler- und Reflektorelektroden.

Figur 3     zeigt den gegen die Frequenz aufgetragenen Impedanzverlauf von parallel bzw. seriell geschalteten Resonatoren.

Figur 4     zeigt den Frequenzgang eines Filters.

Figur 5     zeigt den Frequenzgang eines Filters mit verbesserter linker Flanke.

Figur 6     zeigt den Frequenzgang eines Filters mit verbesserter rechter Flanke.

Figur 7     zeigt den Frequenzgang eines Filters mit verbesserter Selektion.

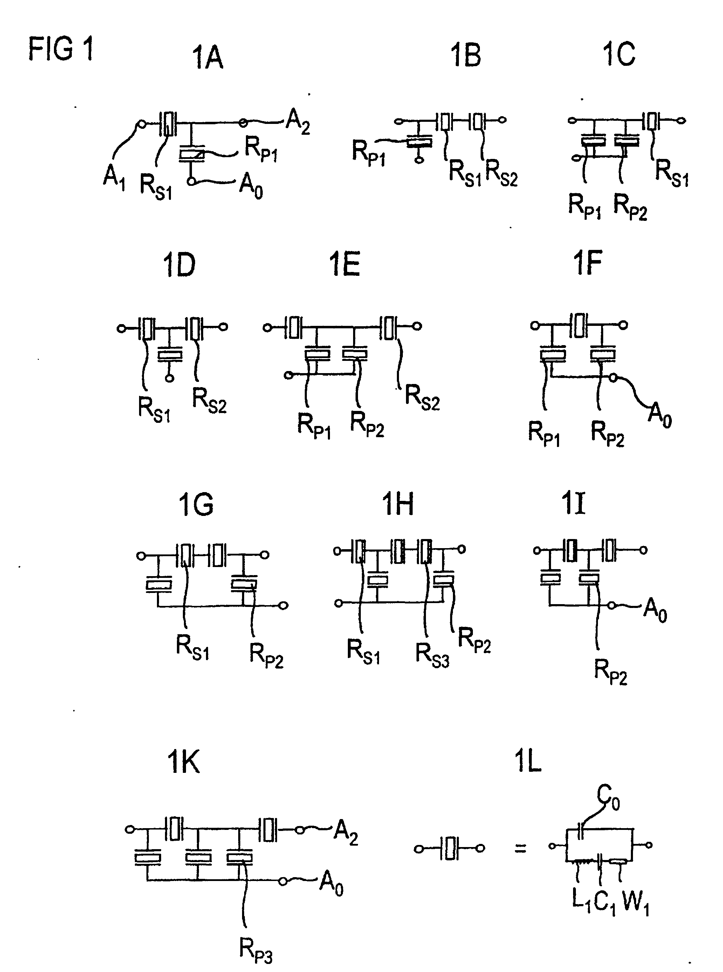

In Figur 1 ist anhand mehrerer Beispiele dargestellt, wie serielle Resonatoren $R_S$ und parallele Resonatoren $R_p$ in einem Filter miteinander verschaltet sein können. Figur 1A zeigt ein Grundglied eines Filters, bei dem ein Resonator $R_{S1}$ zwischen den beiden Anschlüssen A1 und A2 und parallel dazu ein Resonator $R_{P1}$ geschaltet ist, der auf einem beliebigen konstanten Potential, beispielsweise auf Erdpotential, liegt. Ein Grundglied besteht dabei jeweils aus einem solchen Paar von Resonatoren $R_S$ und $R_P$. Jedes mögliche Paar bildet dabei ein Grundglied, wobei sowohl serielle als auch parallele Resonatoren zwei benachbarten Grundgliedern angehören können.

Die Figuren 1B und 1C stellen die einfachsten erfindungsgemäßen Ausführungsformen mit je einem Grundglied ($R_{S1}$, $R_{P1}$) dar. Zusätzlich umfassen die Filter hier noch einen zusätzlichen parallelen oder seriellen Resonator, der keinem Grundglied zugehört. Bei der Figur 1B sind zwei Resonatoren $R_{S1}$ und $R_{S2}$ miteinander in Serie verschaltet, parallel dazu ein Resonator $R_{p1}$. In Figur 1C sind zu einem Resonator $R_{S1}$ zwei Resonatoren $R_{p1}$ und $R_{p2}$ parallel geschaltet.

Figuren 1D bis 1G zeigen aus zwei Grundgliedern bestehende Filter. Die Filter gemäß Figuren 1D und 1E und 1G umfassen zwei serielle Resonatoren $R_{S1}$ und $R_{S2}$, zu denen parallel ein Resonator $R_{P1}$ (Figur 1D) beziehungsweise zwei Resonatoren $R_{P1}$ und $R_{P2}$ parallel geschaltet sind (Figuren 1E und 1G). In Figur 1F ist ein serieller Resonator $R_{S1}$ mit zwei parallelen Resonatoren $R_{P1}$ und $R_{P2}$ verschaltet.

Figur 1H bis 1K zeigen Filter mit drei Grundgliedern. Figur 1H besteht aus drei seriellen Resonatoren $R_{S1}$ bis $R_{S3}$ und zwei parallel dazu geschalteten Resonatoren $R_{P1}$ und $R_{P2}$. Das Filter gemäß Figur 1I besteht aus zwei seriellen und zwei parallelen Resonatoren. Das Filter gemäß Figur 1K besteht aus zwei seriellen und drei parallelen Resonatoren.

Zusätzlich zu den dargestellten Filtern können ebenfalls erfindungsgemäße Filter weitere parallele oder serielle Resonatoren umfassen, die sich jeweils aus der Aufsplittung eines Einzelresonators in zwei seriell bzw. parallel verschaltete Resonatoren ergeben, ähnlich wie die Beispiele gemäß den Figuren 1B und 1C. Im seriellen Zweig der Verschaltung kann ein Resonator $R_S$ durch zwei parallel zueinander geschaltete Resonatoren ersetzt sein, ebenso wie im parallelen Zweig ein Resonator $R_P$ durch zwei serienverschaltete Resonatoren ersetzt sein kann. Figur 1L zeigt das Ersatzschaltbild eines einzelnen Resonators, welcher durch eine statische Kapazität $C_0$ und eine parallel dazu geschaltete Induktivität L1, Kapazität C1 und ohmschen Widerstand W1 umfaßt.

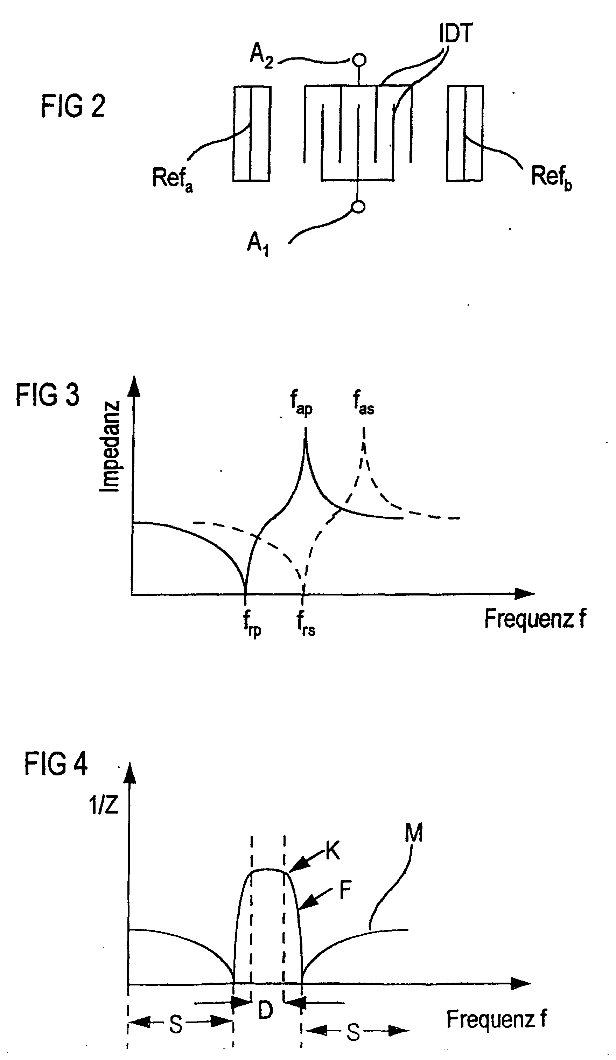

Figur 2 zeigt in schematischer Darstellung, wie ein einzelner Resonator auf einem piezoelektrischen Substrat S aufgebaut ist. Ein jeder Resonator umfaßt dabei einen Interdigitalwandler IDT sowie zwei seitlich davon angebrachte in der Hauptausbreitungsrichtung der Oberflächenwelle liegende Reflektoren $Ref_a$ und

$Ref_b$. Als Substrat kann ein beliebiges piezoelektrisches vorzugsweise monokristallines Material dienen, das in Abhängigkeit von dem gewünschten Durchlaßbereich des Filters ausgewählt ist. Der bereits erwähnte GSM-Standard besitzt beispielsweise eine Systembandbreite von 25 MHz. Der Durchlaßbereich eines dafür geeigneten Filters muß daher mindestens der Systembandbreite entsprechen. Ein solcher Durchlaßbereich läßt sich beispielsweise auf bestimmten Kristallschnitten der piezoelektrischen Substrate Lithiumtantalat Li-$TaO_3$ oder Lithiumniobat $LiNbO_3$ erhalten. Reflektoren Ref und Interdigitalwandler IDT sind als metallische Leiterstrukturen ausgebildet und bestehen beispielsweise aus Aluminium.

Im einfachsten Fall sind die Abstände der Elektrodenfinger der Interdigitalwandler IDT sowie der Gitterabstand in den Reflektoren REF identisch. Unter der Fingerperiode P wird dabei der Mittenabstand zweier benachbarter Finger eines Interdigitalwandlers IDT verstanden. Ein Interdigitalwandler IDT weist mehrere Finger auf, deren genaue Anzahl und deren Überlappung von der gewünschten damit erreichten Impedanz abhängig ist. Typisch besitzt ein Interdigitalwandler IDT 20 bis 300 Finger. Ebenfalls typisch besitzen die Elektrodenfinger eine Breite b, die exakt im Abstand d zum benachbarten Elektrodenfinger des anderen Interdigitalwandlers entspricht. Da die Fingerperiodizität der halben Wellenlänge der erzeugten akustischen Oberflächenwelle entspricht, ist in einem solchen Fall d = b = $\lambda/4$. Zur besseren Reproduzierbarkeit kann der auch als Metallisierungsverhältnis $\eta$ bezeichnete Quotient b/P einen Wert zwischen 0,6 und 0,8 annehmen, wobei d dann entsprechend klein wird (siehe dazu auch zum Beispiel die DE-41 15080 A).

Für ein Filter sind mehrere solcher Spuren mit Resonatoren geometrisch parallel zueinander auf einem gemeinsamen Substrat aufgebracht. Die elektrische Verschaltung der Einzelresonatoren auf einem gemeinsamen Substrat S kann wie in Figur 1 dargestellt erfolgen. Möglich ist es jedoch auch, aus noch mehr Grundgliedern bestehende Filter aufzubauen, die dann auf dem Substrat S eine entsprechend höhere Anzahl an Spuren erfordern.

In Figur 3 ist der Impedanzverlauf zweier Resonatoren gegen die Frequenz aufgetragen. Ein Filter mit einem Durchlaßbereich wird dabei erhalten, wenn mindestens ein Grundglied, bestehend aus einem seriellen und einem parallelen Resonator vorhanden ist. Ein einzelner Resonator besitzt jeweils eine Resonanzfrequenz $f_r$ mit minimaler Impedanz und eine Antiresonanzfrequenz $f_a$ mit maximaler Impedanz. In einem Grundglied eines Filters werden Resonanz bzw. Antiresonanzfrequenzen der seriellen bzw. parallelen Resonatoren im wesentlichen so aufeinander abgestimmt, daß die Resonanzfrequenz $f_{rs}$ des seriellen Resonators $R_S$ der Antiresonanz $f_{ap}$ des dazu parallel geschalteten Resonators $R_p$ entspricht. Auf diese Weise wird ein Filter erhalten, das einen Durchlaßbereich um $f_{rs}$ bezie-

hungsweise $f_{ap}$ aufweist.

Figur 4 zeigt den Frequenzgang eines Filters, bei dem das Amplitudenverhältnis am Filterausgang relativ zum am Filtereingang angelegten Signal gegen die Frequenz f aufgetragen ist. Im Durchlaßbereich D wird ein maximales Signal erhalten. Beiderseits des Durchlaßbereichs weist die Kurve M des Frequenzgangs ein Minimum auf und steigt anschließend wieder auf einen Wert an, der der Sperrbereichsunterdrückung entspricht. Für ein gutes Filterverhalten wird nun angestrebt, einen steilen Übergang F aus dem Durchlaßbereich D in den Sperrbereich S zu erzielen.

Für ein gutes Filterverhalten werden also insbesondere steile Flanken F angestrebt. Auch der Übergang vom Durchlaßbereich zur Flanke, die Kante K, soll möglichst eckig ausgeprägt sein. Es wird daher im Bereich der Kante K ein minimaler Krümmungsradius für die Kurve angestrebt.

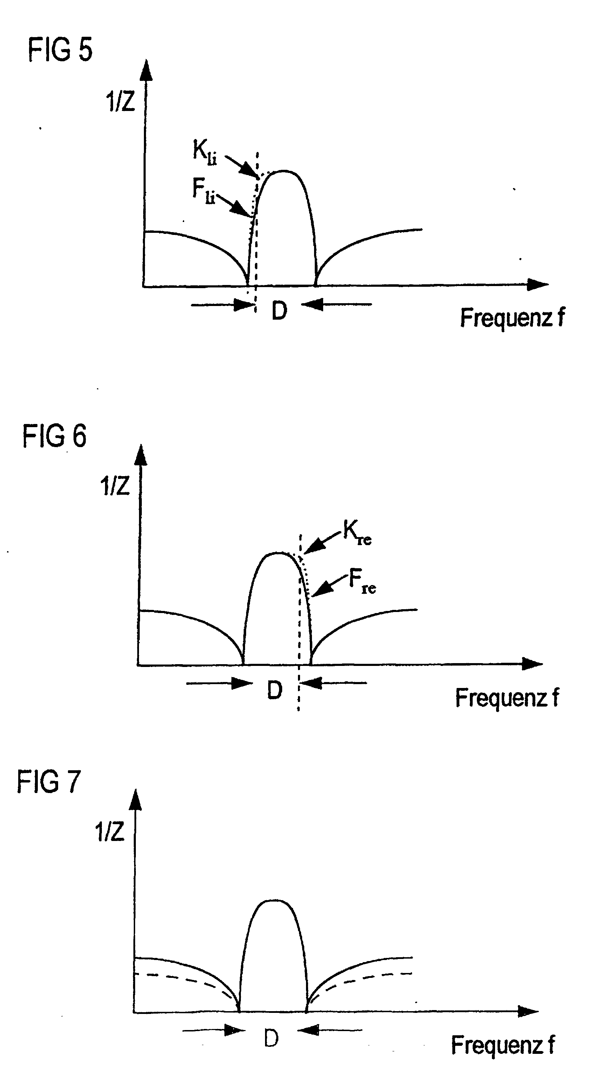

Figur 5 zeigt die Übertragungsfunktion für ein erstes erfindungsgemäßes Filter, bei dem die Resonanzfrequenz $f_r$ der seriellen Resonatoren $R_S$ bzw. die Fingerperiodizitäten der Interdigitalwandler IDT der seriellen Resonatoren voneinander unterschiedlich sind. Die Meßkurve wird beispielsweise bei einem Filter mit drei Grundgliedern erhalten, die gemäß Figur 1H verschaltet sind. Während die durchgezogene Kurve das Filterverhalten eines herkömmlichen Filters zeigt, bei dem die Fingerperiodizitäten $P_S$ der seriellen Resonatoren übereinstimmen, entspricht die gestrichelte Kurve einem erfindungsgemäßen Filter mit unterschiedlichen Fingerperiodizitäten $P_S$ der Interdigitalwandler IDT der seriellen Resonatoren $R_S$. Gleichzeitig weisen die Interdigitalwandler IDT der parallelen Resonatoren $R_P$ identische Resonanzfrequenzen bzw. Fingerperiodizitäten $P_P$ auf.

Aus der Figur 5 wird klar ersichtlich, daß die Übertragungsfunktion M des erfindungsgemäßen Filters eine steilere linke Flanke $F_{li}$ und eine verbesserte Kante $K_{li}$ im Übergang der Flanke zum Durchlaßbereich aufweist. Die rechte Flanke $F_{re}$ bleibt annähernd unverändert. Für die Fingerperiodizitäten $P_S$ der Interdigitalwandler IDT der seriellen Resonatoren gilt $P_{S3} > P_{S1}$, $P_{S2}$ bzw. $P_{S1} < P_{S2}$, $P_{S3}$ bzw. für die sich daraus ergebenden Resonanzfrequenzen $f_{r3} < f_{r1}$, $f_{r2}$ bzw. $f_{r1} > f_{r2}$, $f_{r3}$.

Figur 6 zeigt den Durchlaßbereich eines erfindungsgemäßen Filters, bei dem sich die Fingerperiodizitäten der Interdigitalwandler der parallel geschalteten Resonatoren $R_P$ unterscheiden, und das beispielsweise gemäß Figur 1K verschaltet bzw. ausgebildet ist. Auch hier wird eine Verbesserung der Flanke des Durchlaßbereichs erzielt, die sich bei dieser Ausführung jedoch auf die rechte, zu höheren Frequenzen hinweisende Flanke auswirkt. Die rechte Flanke $F_{re}$ ist deutlich steiler ausgebildet, die entsprechende Kante $K_{re}$ ist schärfer ausgeprägt.

Figur 7 zeigt eine weitere vorteilhafte Verbesserung des erfindungsgemäßen Filters, die zu einer verstärkten Störbereichsunterdrückung führt. Bei dieser Ausgestaltung ist in enger räumlicher Nachbarschaft zu einem parallelen Resonator $R_p$ eine davon elektrisch isolierte metallisierte Fläche angeordnet, die an $A_0$ angeschlosssen ist. Mit dieser metallisierten Fläche gelingt es, die statische Kapazität $C_{0P}$ eines Resonators $R_P$ (siehe $C_0$ in Figur 1L) gezielt so zu beeinflussen, daß das Verhältnis $C_{0P}/C_{0S}$ zur statischen Kapazität $C_{0S}$ des seriellen Resonators $R_S$ erhöht wird. Es war zwar bislang schon bekannt, durch direkte Veränderung der statischen Kapazitäten dieses Verhältnis zu erhöhen, zum Beispiel durch Änderung der Apertur oder der Fingeranzahl der Interdigitalwandler, um eine höhere Störbereichsunterdrückung zu erzielen. Als zwangsläufige Folge wird dabei jedoch auch der Durchlaßbereich D, die Flankensteilheit und die Durchlaßdämpfung verschlechtert, so daß das Filter insgesamt keine Verbesserung erfährt. Mit der erfindungsgemäßen zusätzlichen metallisierten Fläche in der Nachbarschaft eines parallelen Resonators wird jedoch dieses Verhältnis der statischen Kapazitäten positiv beeinflußt, ohne daß die genannten schlechten Nebeneffekte auftreten. Dies führt zu einer erhöhten Störbereichsunterdrückung (siehe gestrichelte Linie in Figur 7), während der Durchlaßbereich im Vergleich zu einem Filter ohne zusätzliche metallisierte Fläche (siehe durchgezogene Linie in Figur 7) unverändert bleibt.

Unabhängig von den erwähnten erfindungsgemäßen Ausgestaltungen können erfindungsgemäße Filter weitere Ausgestaltungen aufweisen, die an sich von herkömmlichen Filtern bereits bekannt sind. So können beispielsweise die seriellen Resonatoren $R_s$ Resonanzfrequenzen $f_{rs}$ aufweisen, die bei der Antiresonanzfrequenz $f_{ap}$ des parallelen Resonators $R_P$ oder leicht darüber liegen. Eine weitere Variation betrifft die Fingerperiodizität der Reflektoren in den parallelen und/ oder seriellen Resonatoren. Letztere können unabhängig von der Erfindung eine gleiche oder unterschiedliche Periode wie die Finger des dazugehörigen Interdigitalwandlers aufweisen. Zusätzlich können die Reflektoren aller seriellen oder aller parallelen Resonatoren jeweils zusammen die gleiche Periode oder in einer weiteren Ausführung auch unterschiedliche Perioden aufweisen. Ebenso kann der Abstand zwischen Interdigitalwandlern IDT und Reflektoren REF ein ungeradzahliges Mehrfaches von λ/4 betragen, oder auch leicht von diesem Wert abweichen.

**Patentansprüche**

1. Oberflächenwellenakustikfilter (SAW-Filter) mit zwei Toren und den Merkmalen

   - mindestens drei Resonatoren ($R_S$, $R_P$) sind in parallel zueinander angeordneten Spuren auf einem Substrat für akustische Oberflächenwellen vorhanden

- jeder Resonator besteht aus einem zwischen zwei Reflektoren angeordneten Interdigitalwandler (IDT), der jeweils ein Paar von elektrischen Anschlüssen sowie mehrere, in einer Fingerperiodizität (P) angeordnete Elektrodenfinger aufweist
- über die Anschlüsse sind Resonatoren $(R_S)$ in Serie und mit Resonatoren $(R_P)$ parallel verschaltet

**dadurch gekennzeichnet, daß**

- von zumindest einem Resonator-Typ, ausgewählt aus in Serie verschalteten Resonatoren $(R_S)$ und parallel verschalteten Resonatoren $(R_P)$, sind mehrere Resonatoren vorgesehen, von denen zumindest zwei bezüglich der Fingerperiodizitäten der Interdigitalwandler (IDT) unterschiedlich sind.

2. SAW-Filter nach Anspruch 1,

   - bei dem n seriell verschaltete Resonatoren $(R_s1, ..R_sx, ...R_sn)$ mit unterschiedlicher Fingerperiodizität $P_S1, ..P_Sx, ..P_Sn$ der Elektrodenfinger der Interdigitalwandler (IDT) vorgesehen sind, wobei n, x ganze Zahlen sind mit n $\geq$ 3 und 1 < x < n,
   - bei dem der Resonator mit der größten Fingerperiodizität $(P^{max})$ in der seriellen Verschaltung außen und der Resonator mit der kleinsten Fingerperiodizität innen angeordnet ist, so daß für zumindest einen Wert x gilt: $P_Sx < P_S1 < P_Sn$.

3. SAW-Filter nach Anspruch 1 oder 2,

   - bei dem vier Grundglieder vorgesehen sind, wobei ein Grundglied einen seriell $(R_S)$ und einen parallel verschalteten Resonator $(R_P)$ umfaßt und ein Resonator zwei Grundgliedern angehören kann,
   - bei dem für die Fingerperiodizität der Elektrodenfinger der seriellen Resonatoren $(R_S)$ gilt
   - $p_S2 < p_S1 = p_S3 < p_S4$ oder $p_S3 < p_S1 = p_S2 < p_S4$.

4. SAW-Filter nach einem der Ansprüche 1 - 3, bei dem die Abweichung der Fingerperiodizität (p) der Interdigitalwandler (IDT) von einer der Mittenfrequenz des Durchlaßbereichs des SAW-Filters entsprechenden Standard-. Fingerperiodizität $(p^{Std})$ 0,1 - 3Prozent beträgt.

5. SAW-Filter nach einem der Ansprüche 1 - 4, bei dem r serielle Resonatoren mit der Standard-Fingerperiodizität $(p^{Std})$ und s serielle Resonatoren mit davon abweichender Fingerperiodizität (p $\neq$ $p^{Std}$) vorgesehen sind, wobei s und r ganze positive Zahlen sind und wobei gilt: $s/r \leq 2$.

6. SAW-Filter nach einem der Ansprüche 1 - 5, bei dem die Resonanzfreqenz $(f_{rS})$ des seriell verschalteten Resonators $(R_S)$ mindestens eines Grundglieds gleich der Antiresonanzfrequenz $(f_{aS})$ des dazugehörigen parallelen Resonators $(R_P)$ ist, wobei ein Grundglied einen seriell $(R_S)$ und einen parallel verschalteten Resonator $(R_P)$ umfaßt und ein Resonator zwei Grundgliedern angehören kann.

7. SAW-Filter nach einem der Ansprüche 1 - 6, bei dem die Resonanzfreqenz $(f_{rS})$ des seriell verschalteten Resonators $(R_S)$ mindestens eines Grundglieds größer ist als die Antiresonanzfrequenz $(f_{aS})$ des dazugehörigen parallelen Resonators $(R_P)$ ist, wobei ein Grundglied einen seriell $(R_S)$ und einen parallel verschalteten Resonator $(R_P)$ umfaßt und ein Resonator zwei Grundgliedern angehören kann.

8. SAW-Filter nach einem der Ansprüche 1 - 7, bei dem die statische Kapazität $C_{OP}$ zumindest eines parallelen Resonators $(R_P)$ durch räumlich nahe Anordnung einer, mit Teilen oder Zuleitungen des Resonators eine Kapazität aufbauenden, Metallisierung auf der Oberfläche des SAW-Filters gezielt so beeinflußt wird, daß ein gewünschtes Verhältnis $C_{OP}/C_{OS}$ zur statischen Kapazität $C_{OS}$ des seriellen Resonators $(R_S)$ erhalten wird.

9. SAW-Filter nach einem der Ansprüche 1 - 8, bei dem das aus dem Quotienten b/P der Breite b der Finger der Interdigitalwandler und deren Periode P gebildete Metallisierungsverhältnis η einen Wert von 0,6 bis 0,8 aufweist.

**Claims**

1. Surface acoustic wave filter (SAW) having two ports and the following features:

   - at least three resonators $(R_s, R_p)$ are provided in tracks, arranged parallel to one another, on a substrate for surface acoustic waves,
   - each resonator comprises an interdigital transducer (IDT) which is arranged between two reflectors and each has a pair of electrical connections as well as a plurality of electrode fingers arranged at a finger periodicity (p),
   - via the connections, the resonators $(R_s)$ are connected in series and are connected in parallel with resonators $(R_p)$,

   **characterized in that**

- a plurality of resonators of at least one resonator type ($R_s$, $R_p$), selected from resonators ($R_s$) connected in series and resonators ($R_p$) connected in parallel, are provided, of which at least two differ with respect to the finger periodicities of the interdigital transducers (IDT).

2. SAW filter according to Claim 1,

   - in which n series-connected resonators ($R_s1$, ..$R_s$x, ..$R_s$n) having a different finger periodicity ($p_s1$, ..$p_s$x, ..$p_s$n) of the electrode fingers in the interdigital transducers (IDT) are provided, where n, x are integers where n $\geq$ 3 and 1 < x < n,
   - in which the resonator having the greatest finger periodicity ($p^{max}$) in the series circuit is arranged on the outside, and the resonator having the smallest finger periodicity is arranged on the inside, so that for at least one value of x, it can be said that: $p_s$x < $p_s1$ < $p_s$n.

3. SAW filter according to Claim 1 or 2,

   - in which four basic members are provided, in which case one basic member comprises a series-connected resonator ($R_s$) and a parallel-connected resonator ($R_p$), and one resonator can belong to two basic members,
   - in which it can be said for the finger periodicity of the electrode fingers of the series resonators ($R_s$) that:

$$p_s2 < p_s1 = p_s3 < p_s4 \text{ or } p_s3 < p_s1 = p_s2 < p_s4.$$

4. SAW filter according to one of Claims 1 - 3, in which the discrepancy in the finger periodicity (p) of the interdigital transducers (IDT) from a standard finger periodicity ($p^{std}$) which corresponds to the mid-frequency of the pass band of the SAW filter is 0.1 - 3 percent.

5. SAW filter according to one of Claims 1 - 4, in which r series resonators having the standard finger periodicity ($p^{std}$) are provided, and s series resonators having a finger periodicity (p $\neq$ $p^{std}$) which differs from this are provided, where s and r are positive integers and where: s/r $\geq$ 2.

6. SAW filter according to one of Claims 1 - 5, in which the resonant frequency ($f_{rs}$) of the series-connected resonator ($R_s$) of at least one basic member is equal to the antiresonant frequency ($f_{as}$) of the associated parallel resonator ($R_p$), with one basic member comprising a series-connected resonator ($R_s$) and a parallel-connected resonator ($R_p$) and in which case one resonator may be associated with two basic members.

7. SAW filter according to in one of Claims 1 - 6, in that the resonant frequency ($f_{rs}$) of the series-connected resonator ($R_s$) of at least one basic member is greater than the antiresonant frequency ($f_{as}$) of the associated parallel resonator ($R_p$), with one basic member comprising a series-connected resonator ($R_s$) and a parallel-connected resonator ($R_p$) and in which case one resonator may be associated with two basic members.

8. SAW filter according to one of Claims 1 - 7, in which the steady-state capacitance $C_{OP}$ of at least one parallel resonator ($R_p$) is influenced deliberately by the physically close arrangement of metallization on the surface of the SAW filter, which metallization forms a capacitance with parts or supply lines of the resonator, so as to produce a desired ratio $C_{OP}/C_{OS}$ to the steady-state capacitance $C_{OS}$ of the series resonator ($R_s$).

9. SAW filter according to one of Claims 1 - 8, in which the metallization ratio $\eta$ formed from the quotient b/P for the width b of the fingers of the interdigital transducers and their period P, has a value of 0.6 to 0.8.

## Revendications

1. Filtre à onde acoustique de surface (filtre SAW) ayant deux portes et les caractéristiques :

   - il est prévu au moins trois résonateurs ($R_s$, $R_p$) dans des pistes disposées parallèlement les unes aux autres sur un substrat pour des ondes acoustiques de surface
   - chaque résonateur est constitué d'un convertisseur (IDT) interdigité interposé entre deux réflecteurs et ayant respectivement une paire de bornes électriques, ainsi que plusieurs doigts d'électrode disposés suivant une périodicité (P) de doigts
   - par les bornes, des résonateurs ($R_s$) sont montés en série et en parallèle avec des résonateurs ($R_p$)

   **caractérisé en ce que**

   - parmi au moins un type de résonateur, choisi parmi des résonateurs ($R_s$) montés en série et des résonateurs ($R_p$) montés en parallèle, il est prévu plusieurs résonateurs, dont au moins deux sont différents pour ce qui concerne la périodicité des doigts du convertisseur (IDT) interdigité.

**2.** Filtre SAW suivant la revendication 1,

- dans lequel il est prévu n résonateurs ($R_s$1, ..., $R_s$x, ..., $R_s$n) montés en série et ayant des périodicités $P_s$1, ..., $P_s$x, ..., $P_s$n différentes des doigts d'électrode du convertisseur (IDT) interdigité, n, x étant des nombres entiers avec n ≥ 3 et 1 < x < n,
- dans lequel le résonateur ayant la périodicité ($P^{max}$) de doigts la plus grande dans le montage série est disposé à l'extérieur et le résonateur ayant la périodicité de doigts la plus petite à l'intérieur, de sorte que pour au moins une valeur de x, on a : $P_s$x < $P_s$1 < $P_s$n.

**3.** Filtre SAW suivant la revendication 1 ou 2,

- dans lequel il est prévu quatre organes de base, un organe de base comprenant un résonateur ($R_s$) monté en série et un résonateur ($R_p$) monté en parallèle et un résonateur pouvant appartenir à deux organes de base,
- dans lequel, pour la périodicité de doigts d'électrode des résonateurs ($R_s$) série, on a
- $p_s$2 < $p_s$1 = $p_s$3 < $p_s$4 ou $p_s$3 < $p_s$1 = $p_s$2 < $p_s$4.

**4.** Filtre SAW suivant l'une des revendications 1 à 3, dans lequel l'écart de la périodicité (p) de doigts du convertisseur (IDT) interdigité à une périodicité ($p^{std}$) de doigts standard correspondant à la fréquence moyenne de la bande passante du filtre SAW est compris entre 0,1 et 3 %.

**5.** Filtre SAW suivant l'une des revendications 1 à 4, dans lequel il est prévu r résonateurs série ayant la périodicité ($p^{std}$) de doigts standard et s résonateurs série ayant une périodicité (p ≠ $p^{std}$) de doigts qui s'en écarte, s et r étant des nombres entiers positifs et s/r ≤ 2.

**6.** Filtre SAW suivant l'une des revendications 1 à 5, dans lequel la fréquence ($f_{rs}$) de résonance du résonateur ($R_s$) monté en série d'au moins un organe de base est égale à la fréquence ($f_{as}$) d'anti-résonance du résonateur ($R_p$) parallèle associé, un organe de base comprenant un résonateur ($R_s$) monté en série et un résonateur ($R_p$) monté en parallèle et un résonateur pouvant appartenir à deux organes de base.

**7.** Filtre SAW suivant l'une des revendications 1 à 6, dans lequel la fréquence ($f_{rs}$) de résonance du résonateur ($R_s$) monté en série d'au moins un organe de base est supérieure à la fréquence ($f_{as}$) d'anti-résonance du résonateur ($R_p$) en parallèle associé, un organe de base comprenant un résonateur ($R_s$) monté en série et un résonateur ($R_p$) monté en parallèle et un résonateur pouvant appartenir à deux organes de base.

**8.** Filtre SAW suivant l'une des revendications 1 à 7, dans lequel la capacité $C_{OP}$ statique d'au moins un résonateur ($R_p$) monté en parallèle est influencée par l'agencement à proximité dans l'espace sur la surface du filtre SAW d'une métallisation constituant, avec des parties ou des lignes d'entrée du résonateur, une capacité, de façon à obtenir un rapport $C_{op}/C_{os}$ souhaité par rapport à la capacité $C_{os}$ statique du résonateur ($R_s$) monté en série.

**9.** Filtre SAW suivant l'une des revendications 1 à 8, dans lequel le rapport η de métallisation formé du quotient b/p de la largeur b du doigt du convertisseur interdigité et de sa période P a une valeur de 0,6 à 0,8.

FIG 1

FIG 2

FIG 3

FIG 4

FIG 5

FIG 6

FIG 7